# EUROPEAN PATENT APPLICATION

(11) **EP 0 797 305 A1**
(43) Date of publication of application: **24.09.1997**
(21) Application number: 96830145.7
(22) Date of filing: 22.03.1996
(51) Int. Cl.: H03M 1/02, H03M 1/46

(54) **Combined ADC-DAC**

(71) Applicant: SGS-THOMSON MICROELECTRONICS s.r.l., 20041 Agrate Brianza (Milano) (IT)
(72) Inventor: Fucili, Giona, 20013 Magenta (IT); Leone, Marcello, 20017 Rho (IT); Rossi, Anna Maria, 16154 Genova (IT)
(74) Representative: Pellegri, Alberto

(57) **Abstract**

A combined system of analog/digital and digital/analog conversion shares a common digital/analog converter circuit (DAC) and the comparator (COMP) associated thereto and a register of successive approximations (SAR) and is configured on a time-division mode by a dedicated logic circuit (CONTROL LOGIC) through at least a digital multiplexer (MUX1) to perform analog/digital conversion functions and digital/analog conversion functions over a plurality of channels. The system achieves an outstanding net saving of integration area.

## Description

The present invention relates to a combined digital/analog and successive approximations analog/digital conversion system that may be configured for either one or the other mode of operation.

Digital/analog converters (DAC) often represent the last stages of digital systems for controlling, regulating or generally converting a certain digital datum as processed by the control circuitry, into an analog quantity. In practice, they act as interfaces with the real world which generally is based on analog parameters.

Likewise, analog/digital converters (ADC) may be considered as interfaces through which analog parameters representing a real world condition are converted into digital data more readily manageable to storing and processing them by the use of combinatory logic circuitry, memories, microprocessors and the like.

Many systems require the existence of both digital/analog converters and analog/digital converters, in order to implement closed loops for regulation and control in a digital form, more readily manageable via software.

As known, a digital/analog converter (DAC) circuit may be constituted by a network having a plurality of calibrated capacitive or resistive branches that may be selected through switches, according to a configuration corresponding to an input digital word so to produce a certain level of current or voltage on a common node of the network, in function of the switch configuration, that is of the digital input datum.

Considering that in the majority of cases DAC converters are utilized for generating an analog signal that must be compared with another signal, for example a fedback signal, to "turn-on" or "turn-off" the cause of the variation of a certain controlled parameter, the comparator is often considered as an integral part of a DAC and it is often the combination DAC+Comparator which is unimproperly referred to as a DAC.

On the other hand, a widely employed type of analog/digital converter (ADC) circuit is of the so-called "successive-approximations" type, whereby an input analog voltage (to be converted) is compared with a voltage "built" by an internal digital/analog converter (DAC) circuit that constitutes the "core" of the ADC converter.

The digital input of the internal DAC is provided by a dedicated register (SAR) containing the current approximated digital value. The SAR, which through successive updatings gradually builds a voltage closer and closer (by excess of defect) to the value of the input analog voltage, is sequentially updated in function of the result of the comparison performed by the comparator. After a certain number of comparisons, equal or greater than the number of bits of the converter, the content of the SAR represents the digital result of the conversion, completed by a process of successive approximations, and as such may be "read" by the digital system.

As known, one of the main causes of problems of successive approximation ADC converters, is the existence of "mismatchings" of the physical magnitudes that establish the relative calibrating ratios among the distinct branches of the network of the internal DAC. For example, an imprecise ratio among the values of the different capacitances or resistors that form the selectable branches of the internal DAC, would provoke a wrong conversion of the current digital value contained in the successive approximation register into an analog electrical parameter (deriving from a capacitive or resistive distribution of a certain reference bias voltage or current in the network of the internal DAC.

Effective methods have been proposed for trimming or adjusting eventually detected "mismatchings" that permit to attain fully satisfactory conversion accuracies, obviously referred to the number of bits of the converter.

An efficient correction system for the so-called "missing codes (bits)" problem, caused for example by a capacitive "mismatching" of successive approximation ADC is described in the European Patent Application No. 93830503.4 filed on 15 December 1993, in the name of the present applicant, and whose description is herein incorporated by way of reference.

In many applications of regulation and control systems that employ one or more DAC and one or more ADC, the way the system as a whole operates, practically exclude that the two kinds of conversion may occur simultaneously.

For example, in the control system of inkjet printers, a DAC is often used for controlling the overheating of the printing heads and an ADC is used for maintaining the environmental temperature in which the heads operate, the resistivity of the active elements of the heads and other analog parameters of operation.

It has now been found, and constitutes the object of the present invention, a combined A/D and D/A converting system capable of exploiting a common circuital core, which can be alternatively used as DAC or as an ADC, as long as this occurs at different times.

By assuming that by an approximate calibration of the "core" of an ADC, constituted by an internal DAC and by a Comparator any "mismatching" be effectively corrected so as to ensure a satisfactory precision in the analog-to-digital conversion process from the combined circuitry of the DAC+Comparator will be intrinsically correct if used for performing a digital/analog conversion.

The combined system of the invention is configured in either of the two operative scheme by a dedicated control circuitry, thus achieving a remarkable net saving of integration area and a proportionally reduced cost of the whole integrated system.

A further advantage offered by the configurable bifunctional converter circuit of the invention consists in an excellent "tracking" between the two modes of conversion if compared to the case of using distinct ADC and DAC converters.

According to a particularly effective embodiment of the invention, the combined system of D/A or A/D conversion because it is built intrinsically to function in a substantially "time division" mode, can optimally handle in a "time division" mode, a relatively high number of parameters, either as a DAC or as an ADC.

A more generalized definition of the combined bifunctional system of the invention is defined in claim 1, whereas particularly effective embodiments are defined in the subsequent claims.

The various aspects and advantages of the system of the invention will become even clearer through the following description of some important embodiments and by referring to the attached drawings, wherein:
**Figure 1** is a typical application scheme of a DAC;
**Figure 2** is a successive approximation DAC functional scheme;
**Figure 3** shows the basic architecture of a configurable bifunctional combined A/D and D/A conversion system, according to the present invention;
**Figure 4** shows the architecture of a combined system of the invention capable of handling, in a time division mode, a plurality of digital variables convertible to analog magnitudes and a plurality of analog variables convertible into digital values;
**Figure 5** is a block diagram of a combined converter of the invention for a specific application.

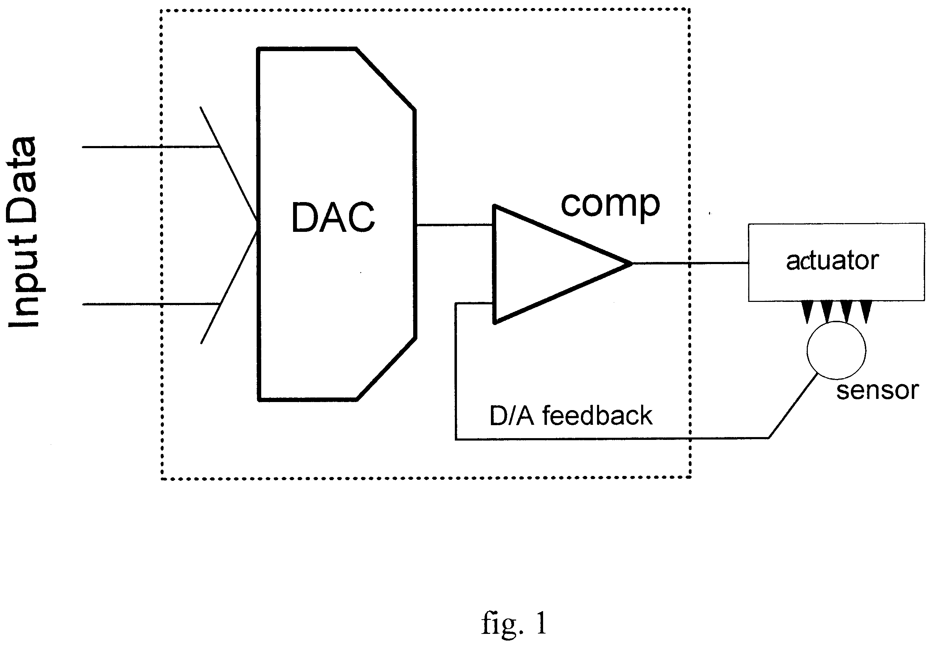

Fig. 1 illustrates a typical application of a DAC for driving and controlling a generic external device (actuator) in function of digital command data (input data) and of the value of an analog parameter sensed by a dedicated transducer (sensor).

Of course, the network that realizes the circuit of digital-to-analog conversion DAC may be anyone of the many networks known in the art, either of the capacitive or resistive type.

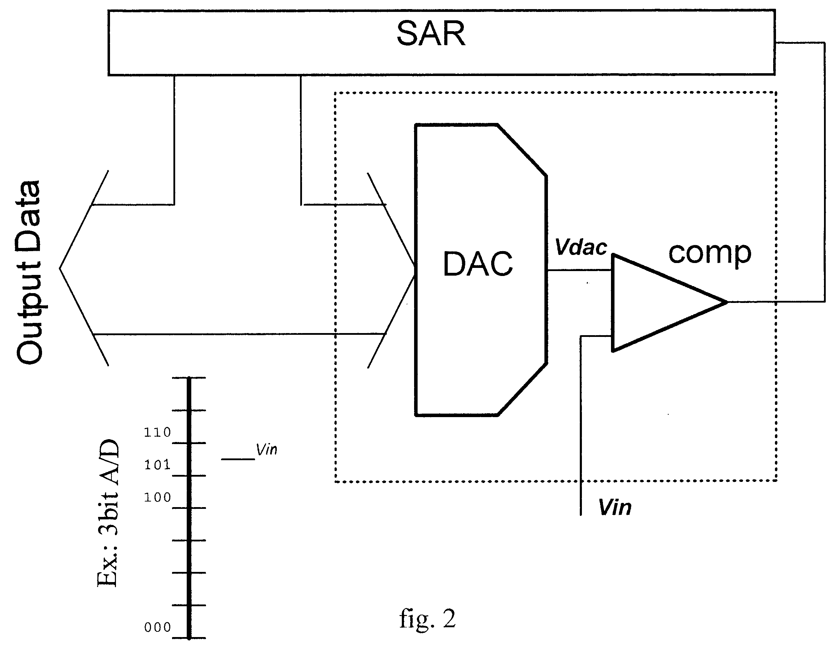

Fig. 2 is a functional scheme of a typical successive approximation ADC. The SAR register, commonly installed with an average digital value in respect of the normal range of variation of the analog magnitude to be converted, defines the configuration of the network of the internal DAC and is constantly updated by the result of the comparison between the analog value Vdac output by the DAC with the input analog magnitude Vin. Through successive approximations, the loop is such as to reach a condition whereby the voltage Vdac is equivalent (within the discrimination limit of the converter) to the input analog value Vin. In this condition, reached stepwisely, through successive approximations, the content of the SAR register provides the digital value (output data) corresponding to the input analog value Vin.

The conversion scale shown at the bottom left side of Fig. 2 shows how an ADC converter using a "core" constituted by a 3-bit DAC circuit is capable of outputting a 3 bit digital value corresponding to the input analog value Vin, with the approximation provided by the number of bits of the internal DAC.

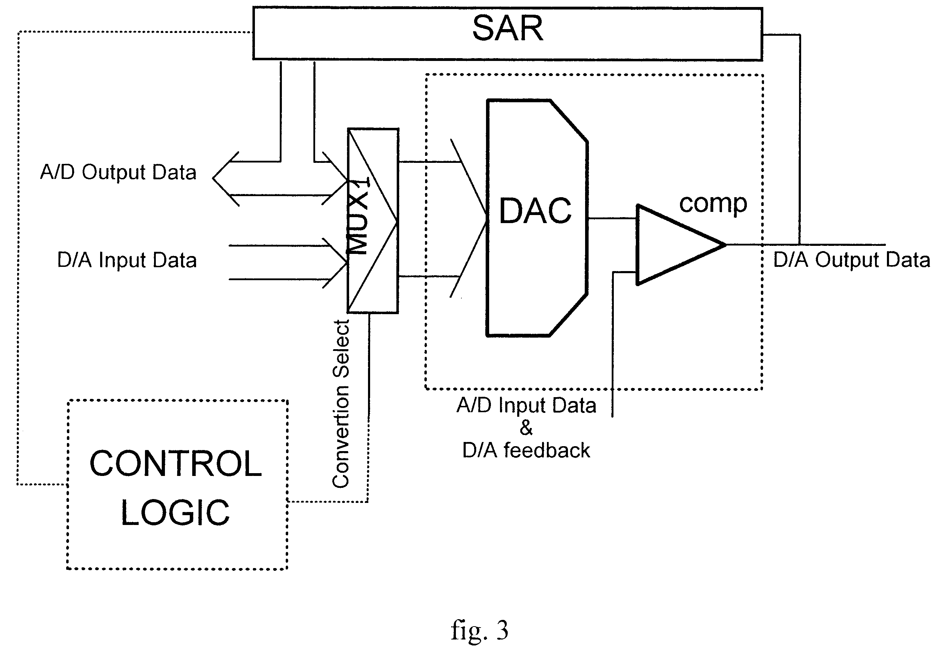

Fig. 3 shows the basic architecture of a configurable, combined digital/analog or analog/digital conversion system, according to the present invention.

Basically, the system of the invention consists in using a digital multiplexer MUX1 for selecting the digital value to be fed to the internal DAC, thus permitting to alternatively select either the digital word contained in the SAR register in a phase of operation of the converter as an ADC, or a generic digital input data (D/A Input Data) in a phase of operation of the converter as a DAC.

Of course, depending on the current configuration of the converter, at the input of the comparator COMP will be supplied either a voltage representative of the analog magnitude (A/D Input Data) to be converted into a digital datum, or an eventual analog control signal. Such as for example a signal generated by a sensor (D/A feedback), according to an application scheme as that of Fig. 1.

A logic circuit, schematized in the figure by the block CONTROL LOGIC, make the selection through the multiplexer MUX1, in function of commands generated by a system's controller and of a certain timing determined by the duration of the cycle of the successive approximation ADC.

As said above, the two configurations, as DAC or as an ADC, of the combined converter of the invention are mutually exclusive and for each particular phase of operation, the system as a whole, the combined converter is configured either as DAC or as ADC, basically on a time division scheme.

The configurable, combined converter system of the invention is particularly useful for performing multiple functions of DAC and ADC conversion for a plurality of variables or parameters, on a time division base, coordinated by a system's controller.

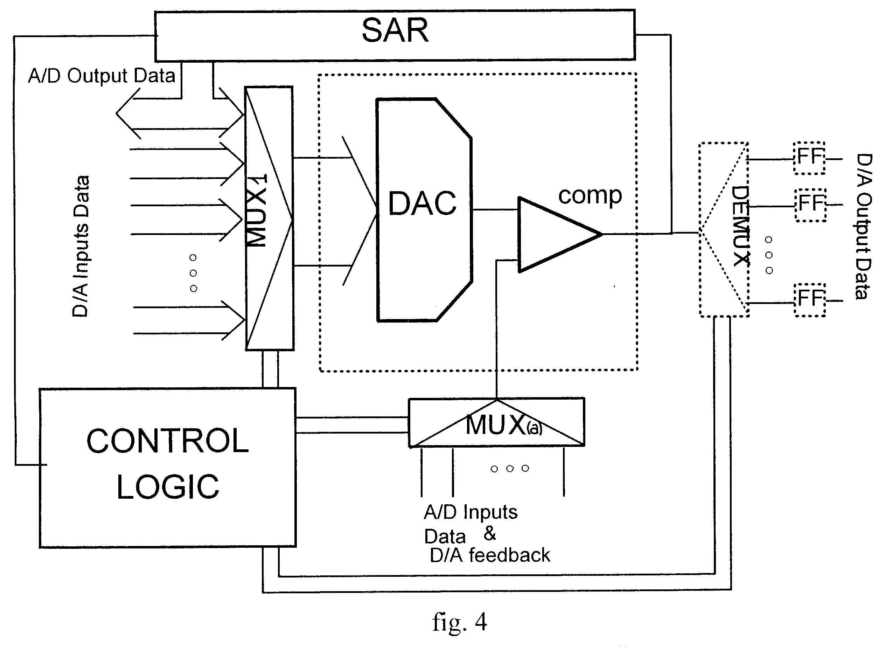

Therefore, according to a preferred embodiment, the architecture of the combined ADC-DAC converter of the invention may be schematized as shown in Fig. 4.

According to this embodiment, the digital input multiplexer MUX1 may handle a plurality of inputs (D/A Input Data) besides the digital value stored in the SAR register.

Moreover, an analog multiplexer MUXa, also selected by the control circuit (CONTROL LOGIC), perform a selection among a plurality of analog signals to be converted (A/D input data) beside analog control signals (D/A feedback), during a phase of configuration as a DAC, according to an application scheme as the one shown in Fig. 1.

The combined system of the invention allows, through a demultiplexing process, to store the results of successive D/A conversions, carried out in sequence, in relation to a plurality of conversion channels, in an array of dedicated registers FF1, FF2, ..., FFn, ..., one for each digital input selectable through MUX1.

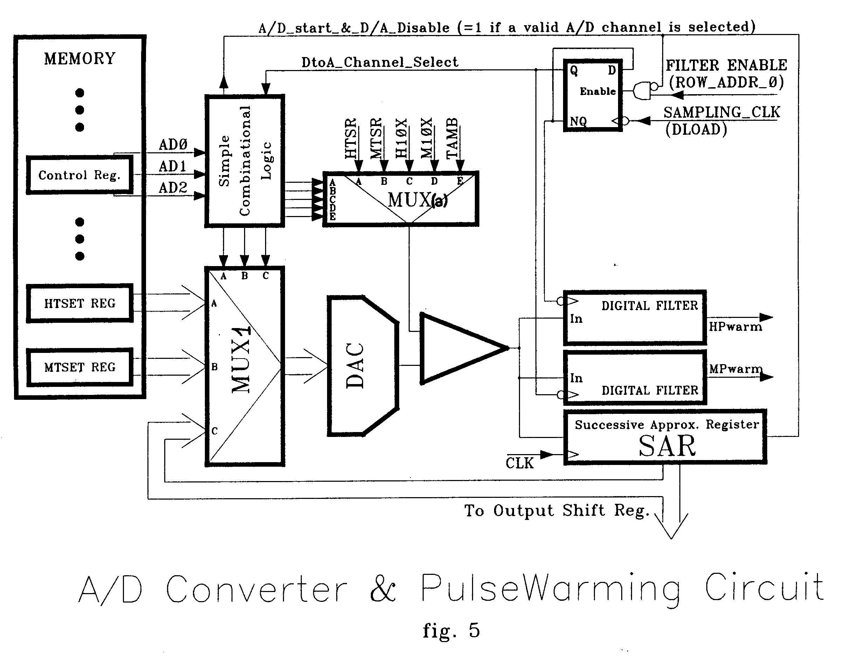

Of course, this possibility can be implemented by enabling, on a case by case basis, the relative register through its clock input or in the alternative, as schematized in Fig. 5, by employing a demultiplexer DEMUX.

Even in this embodiment, the block CONTROL LOGIC provides to make the appropriate selections through the digital multiplexer MUX1, the analog multiplexer MUXa and eventually the digital demultiplexer DEMUX (or to selectively enable the relative register).

An example of application of the combined ADC-DAC converter of the invention for an inkjet printer is shown in a schematic and simplified manner in Fig. 5.

The handled analog parameters may be for example:
- the voltages representative of the temperature of two heads of the printer, namely HTSR and MTSR;
- the voltages representative of the resistivity of certain elements, H10X and M10X;
- the voltage representative of the environmental temperature, TAMB.

These are fed to the respective inputs A, B, C, D ,E of the analog multiplexer MUXa.

The input digital parameters handled are HTSET and MESTA. These may be stored in dedicated registers (HTSETREG and MTSETREG) and their value represents the temperature that must be maintained at the printer heads.

The choice for the type of conversion occurs by the signals AD0, 1,2.

If AD(0:2)=000,the channels HTSR and MTSR are selected alternatively (through the enableable flip-flop). At the same time, the DAC receives as input the corresponding digital datum (HTSET or MTST). Thus, if AD(0:2)-000, the system operates as a closed loop D/A converter by the H/MTSR signals. The result of the comparison between HTSR/MTSR and H/MTSET is stored in the relative digital filter which, beside to its pulse rejecting function, acts as a memory. Its output switches on or off the heater of the relative head. It should be noticed that there is not any DEMULTIPLEXER because this function is advantageously and automatically performed by the system (through the enableable flip-flop) that manages the storing functions of the filters.

If AD(0:2)>000 then an analog channel is selected among A, B, C, D, E (001,010, ...) and A/D conversion starts, disabling the preceding function (D/A) by disabling the storing system represented by the digital filters through the aforementioned flip-flop.

## Claims

1. A combined system of analog/digital and digital/analog conversion comprising a common digital/analog converter circuit (DAC) capable of receiving as input an n bit digital datum and of outputting an analog signal of a corresponding magnitude, a single comparator (COMP) capable of comparing said analog signal applied to a first input with a variable analog signal applied to a second input, and a single register of successive approximation data (SAR) updatable in function of the result of the comparison carried out by said comparator (COMP) and to output an m bit digital value representing the digital result of a completed conversion of said variable analog signal, characterized in that it comprises
a digital multiplexer (MUX1) receiving through the respective inputs said m bit digital value present in said successive approximation register (SAR) and at least a digital input datum to be converted and having outputs connected to the inputs of said digital/analog converter circuit (DAC);
a circuit (CONTROL LOGIC), synchronized with the sampling and updating period of said successive approximation register (SAR), commanding the selection of said input datum or of said digital value by said multiplexer (MUX1).

2. The combined system of conversion according to claim 1, characterized in that it comprises
an analog multiplexer (MUXa) receiving through respective inputs a plurality of analog signals selectable by commands of said logic circuit CONTROL LOGIC.

3. The combined system of conversion according to claim 2, characterized in that it comprises
demultiplexing means capable of storing digital data produced in succession by said comparator (COMP) in respective registers (FF), during a phase of operation in a time division mode of the system in relation to a plurality of conversion channels.
